# EUROPEAN PATENT APPLICATION

(11) **EP 4 300 593 A1**
(43) Date of publication of application: **03.01.2024**
(21) Application number: 22189309.2
(22) Date of filing: 08.08.2022
(51) Int. Cl.: H01L 31/0224, H01L 31/05

(54) **WELDING METHOD FOR PHOTOVOLTAIC CELL AND PHOTOVOLTAIC MODULE**

(30) Priority: 27.06.2022 CN 202210742338
(71) Applicant: JINKO SOLAR CO., LTD, Jiangxi 334100 (CN); Zhejiang Jinko Solar Co., Ltd., Haining, Zhejiang 314416 (CN)
(72) Inventor: TAO, Wusong, HAINING, 314416 (CN); LI, Tingting, HAINING, 314416 (CN); CAO, Jingyu, HAINING, 314416 (CN)
(74) Representative: DREISS Patentanwälte PartG mbB

(57) **Abstract**

Disclosed are a welding method for a photovoltaic cell and a photovoltaic module. First and second cells are adjacent to each other and welded to each other by a solder strip. The welding method includes providing a substrate of each of the first cell and the second cell, and providing a first solder layer at a preset position of the substrate where an electrode pad of the substrate is located; and lapping one end of the solder strip on the first solder layer of the first cell, lapping another end of the solder strip on the first solder layer of the second cell, and connecting the first cell and the second cell together by welding. A lower welding temperature is required, over-welding and de-welding are reduced, a contact area between the solder strip and the first solder layer is larger, the tension is stable, and better reliability is achieved.

## Description

### TECHNICAL FIELD

The present disclosure relates to the technical field of photovoltaic solar energy, and in particular to a welding method for a photovoltaic cell and a photovoltaic module.

### BACKGROUND

Electrode pads on the cell in the related art have relatively large size, and a fluxing layer of a solder strip is thick (15 µm - 20 µm). However, the actual contact area between the fluxing layer and the electrode pad is still small, resulting in a small welding tension, and large tin sweats are easily formed after heating, which affects the reliability of products.

### SUMMARY

The present disclosure provides a welding method for a photovoltaic cell. The photovoltaic cell includes a first cell and a second cell that are adjacent to each other and are welded to each other by a solder strip. The welding method for the photovoltaic cell includes: step S1: providing a substrate of each of the first cell and the second cell, and providing a first solder layer at a preset position of the substrate where an electrode pad of the substrate is located; and step S2: lapping one end of the solder strip on the first solder layer of the first cell, lapping another end of the solder strip on the first solder layer of the second cell, and connecting the first cell and the second cell together by welding.

In some embodiments, each of the first cell and the second cell comprises an electrode, and the electrode pad is located on the electrode.

In some embodiments, step S1 includes: firstly, infiltrating a coating member with a first solder, drawing the infiltrated coating member the preset position of the substrate, and then heating the coating member in such a manner that the substrate is coated with the first solder to form the first solder layer.

In some embodiments, the first solder layer has a thickness within a range of 2 µm to 10 µm.

In some embodiments, the first solder layer is heated at a temperature of 170 °C - 220 °C for less than 10 seconds.

In some embodiments, a ratio of a width of the first solder layer to a width of the electrode pad is greater than 50%.

In some embodiments, step S2 includes: drawing the solder strip onto the first solder layer, wherein the solder strip comprises a solder strip body and a second solder layer covering the solder strip body; and lapping the first solder layer with the second solder layer.

In some embodiments, the second solder layer has a thickness within a range of 1 µm to 13 µm.

In some embodiments, in a molten state, a ratio of a thickness of the second solder layer to a thickness of the first solder layer is 3:7.

In some embodiments, in a molten state, the second solder layer has a wetting angle smaller than 90°.

In some embodiments, the second solder layer is coated on the solder strip body by electroplating or hot dipping.

In some embodiments, the solder strip body has a diameter of 0.3 mm, and the second solder layer has a thickness of 4 µm.

In some embodiments, the first solder layer and the second solder layer are tin-lead alloy solder layers or tin-lead-silver alloy solder layers, and the tin-lead alloy solder layers and the tin-lead-silver alloy solder layers comprise Sn-Ag, Sn-Pb, Sn-Cu, Sn-Bi, or Sn-Ga-Bi.

In some embodiments, the electrode pad has a size of 0.8 mm ^{∗} 0.5 mm.

The present disclosure also provides a photovoltaic module. The photovoltaic module includes a cell string formed by connecting a plurality of cells in sequence, a packaging layer configured to cover a surface of the cell string, and a cover configured to cover a surface of the packaging layer away from the cell string. The two adjacent cells of the plurality of cells are connected to each other through any one of the above welding methods.

### BRIEF DESCRIPTION OF DRAWINGS

FIG. 1 is a schematic diagram illustrating that a first cell and a second cell are connected by a solder strip according to the present disclosure;
FIG. 2 is a schematic diagram of a cell formed after step S1 according to the present disclosure;
FIG. 3 is a schematic diagram of a cell formed after step S2 according to the present disclosure; and
FIG. 4 is a schematic diagram of a photovoltaic module according to the present disclosure.

Description of reference numerals: 1-first cell, 2-second cell, 3-solder strip, 4-substrate, 5-first solder layer, 6-solder strip body, 7-second solder layer, 8-electrode pad, 9-cell string, 10-packaging layer, and 11-cover.

### DESCRIPTION OF EMBODIMENTS

The embodiments described below with reference to the accompanying drawings are exemplary and only for explaining the disclosure, rather than limiting the disclosure.

In the prior art, in the production of connecting multiple cells in series by solder strips to form a cell string, ends of the solder strips with a predetermined length are usually aligned with each other and then are placed on front busbars of a front cell, and another ends of the solder strips are placed on rear busbars of a rear cell. Currently, the solder strip is basically in point-line contact with the electrode pad. In order to ensure the welding tension, this method has a higher requirement on the thickness of the fluxing layer of the solder strip, and requires higher welding temperature and longer welding time.

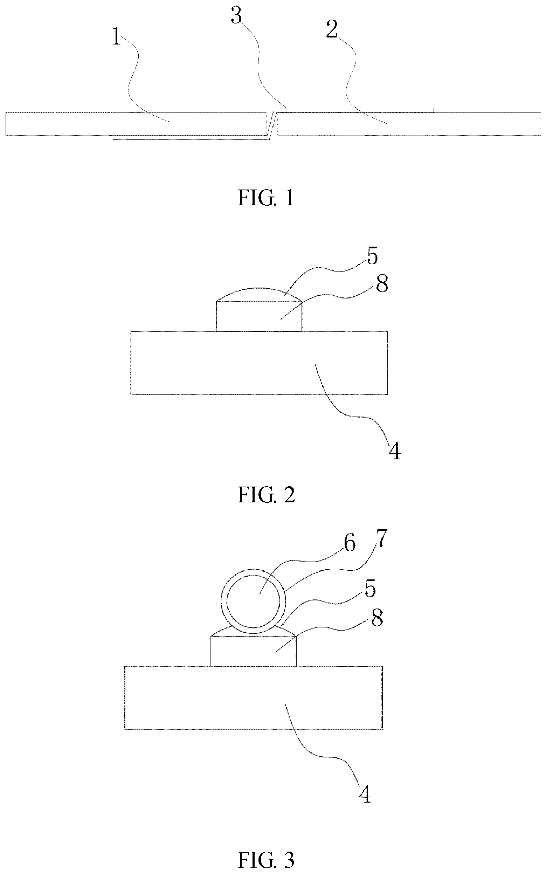

In view of the above, as shown in FIG. 1 through FIG. 3, the present disclosure provides a welding method for a photovoltaic cell. A first cell 1 and a second cell 2 and the first cell 1 are adjacent to each other and are welded to each other by a solder strip 3. The welding method includes step S1 and step S2.

At step S1, referring to FIG. 2, each of the first cell 1 and the second cell 2 includes a substrate 4 made of a silicon wafer material, and a first solder layer 5 is arranged at a preset position of the substrate 4. The first solder layer 5 has a fluxing function, which can enhance the welding tension of the solder strip 3, thereby avoiding the problem of rosin joint or insufficient tension during the welding process, and improving the weldability of the solder strip 3.

At step S2, referring to FIG. 1 and FIG. 3, one end of the solder strip 3 is lapped on the first solder layer 5 of the first cell 1, another end of the solder strip 3 is lapped on the first solder layer 5 of the second cell 2, and the first cell 1 and the second cell 2 are connected together by welding.

Referring to FIG. 1, in some embodiments, one end of the solder strip 3 is connected to a bottom end of the first cell 1, and another end of the solder strip 3 is connected to a top end of the second cell 2. Since the first solder layers 5 are respectively arranged at the preset position of the first cell 1 and the preset position of the second cell 2 in advance, the first solder layer 5 has a fluxing function, thereby reducing or even canceling the fluxing layer originally covering the solder strip 3. In this way, compared with the related art, the surface of the solder strip 3 can be in sufficient contact with an electrode pad 8, thereby increasing the contact area and ensuring a greater welding tension. In this way, the pressure of the solder strip 3 is smaller in the welding process, and the risk of cracking is reduced. Meanwhile, the area of the electrode pad 8 can be reduced, which reduces the consumption of silver paste and is beneficial to reducing the production cost.

In some embodiments provided in the present disclosure, both the first cell 1 and the second cell 2 include an electrode (not shown), and the first solder layer 5 covers the electrode pad 8 located on the electrode. The electrode is arranged at least on a front side of the substrate 4, and can also be arranged on a back side of a semiconductor substrate. In some embodiments, the electrode includes multiple busbars and multiple finger electrode lines. The multiple busbars and the multiple finger electrode lines cross. Each busbar is electrically connected to multiple finger electrode lines. The finger electrode lines are configured to collect a photo-generated current generated by a solar cell. The busbars are configured to collect the current on finger electrode lines. The first solder layer 5 is arranged on the busbars, and the solder strip 3 is welded to the busbars to achieve current transmission between the two cells, so that the collected current is led to the outside of the solar cell through the solder strip 3.

In some embodiments provided by the present disclosure, at step S1, firstly, a coating member (not shown) is infiltrated with a first solder, the infiltrated coating member is drawn to a preset position of the substrate 4, and then the coating member is heated so that the first solder is coated on the substrate 4 to form the first solder layer 5. The coating member can be made of wire strand to achieve a good infiltration effect. A width of the wire strand can be fit to a width of the busbars. The wire strand is infiltrated with the first solder in the molten state, and the first solder is guided to the wire strand utilizing capillary of the wire strand, so that the surfaces of the wire strand are coated with the first solder. The wire strand covered with the first solder is drawn to the busbar of the first cell 1 or the busbar of the second cell 2. By heating the wire strand, the first solder covering the surfaces of the wire strand is molten, and the wire strand is then drawn so that the first solder is transferred from the wire strand to the busbar. The busbar is uniformly coated with the first solder layer 5 before welding the solder strip.

It is acknowledged by those skilled in the art that in addition to the coating operation by using the coating member, the first solder layer 5 can also be formed on the substrate 4 by various methods such as printing or spot coating.

In some embodiments provided in the present disclosure, the first solder layer 5 has a thickness within a range of 2 µm to 10 µm, including endpoint values. For example, the thickness can be 2 µm, 4 µm, 6 µm, 8 µm, 10 µm, or the like. The thickness can also be other values within the above range, which is not limited herein. If the first solder layer 5 is too thin, the welding quality will be affected, the welding fastness will be reduced, and the risk of over-welding and de-welding will occur. If the first solder layer 5 is too thick, the production cost will be increased, and a large tin sweat is easily formed after heating, which affects the reliability of the products and increases the risk of cracking.

In some embodiments provided in the present disclosure, the coating member is heated at a temperature of 170-220°C for less than 10s. Within this range, the first solder layer 5 maintains good fluidity, so that the first solder covering the coating member can be fully and uniformly transferred to the busbars, thus forming a layer of uniform first solder layer 5 with a proper thickness.

In some embodiments provided in the present disclosure, a ratio of a width of the first solder layer 5 to a width of the electrode pad 8 is greater than 50%, and the first solder layer 5 covers at least half of the electrode pad 8, so as to prevent the problem of ineffective bonding between the solder strip 3 and the electrode pad 8 and improve the weldability of the solder strip 3. In some embodiments provided in the present disclosure, at step S2, referring to FIG. 3, the solder strip 3 includes a solder strip body 6 and a second solder layer 7 covering the solder strip body 6. The second solder layer 7 also has a fluxing function, which can enhance the welding tension of the solder strip 3, thereby avoiding the problem of rosin joint or insufficient tension during the welding process and improving the weldability of the solder strip 3. The second solder layer 7 is coated on the solder strip body 6 by electroplating or hot dipping. For specific process parameters and process routes, reference can be refer to the relevant content in the related art, which will not be repeated herein.

The solder strip 3 is drawn onto the first solder layer 5, and the first solder layer 5 is lapped with the second solder layer 7. Since the first solder layer 5 is pre-coated on the busbars, the first solder layer 5 and the second solder layer 7 cooperate together to have a fluxing function, thereby reducing the thickness of the second solder layer 7 and achieve a thinner and more uniform second solder layer 7. In some embodiments, the second solder layer 7 can even be eliminated and the fluxing function is completely played by the first solder layer 5.

In some embodiments provided in the present disclosure, the second solder layer 7 covering the solder strip body 6 has a thickness within a range of 1 µm to 13 µm. For example, the thickness can be 1 µm, 3 µm, 5 µm, 7 µm, 9 µm, 11 µm, 13 µm, or the like. The thickness can also be other values within the above range, which is not limited herein. Compared with the prior art, the solder strip 3 has a thick fluxing layer (15 µm - 18 µm) and the thickness of the second solder layer 7 is relatively small, thereby effectively reducing the cost of the solder strip 3. In addition, by pre-coating the first solder layer 5, the solder strip 3 is bonded to the first solder layer 5 during actual welding. In this way, a lower welding temperature is required, the risk of over-welding and de-welding is reduced, the contact area between the solder strip 3 and the first solder layer 5 is relatively large, the tension is more stable, and better reliability is achieved.

In some embodiments provided in the present disclosure, in the molten state, a ratio of a thickness of the second solder layer 7 to a thickness of the first solder layer 5 is 3:7. The relatively thick second solder layer 7 is arranged at the electrode pad 8 in advance, so that the thickness of the first solder layer 5 can be reduced accordingly and the thickness ratio is within a reasonable ratio, thereby enhancing the adhesion between the solder strip 3 and the electrode pad 8, improving the welding reliability, and improving the quality of the solar cell.

In some embodiments provided in the present disclosure, in the molten state, the second solder layer 7 has a wetting angle smaller than 90°. The wetting angle refers to an angle between an interface between a solder and a base material, and a tangent to the surface of the solder after the solder is molten. When the wetting angle is smaller than 90°, the effective reflective multiplexing area can be increased, and it also can avoid the situation where the second solder layer 7 is molten and flows to form tin sweats accumulating on the front side of the electrode pad 8, resulting in leakage of electricity due to the punctured film.

Referring to Table 1, taking the solder strip body 6 with a diameter of 0.3mm as an example, under the premise of ensuring the welding effect, the thickness of the second solder layer 7 can be reduced from the current 17 µm to 4 µm, which can save about 77.4% of the the solder layer of the solder strip.

Taking the electrode pad 8 with a size of 0.8 mm ^{∗} 0.5 mm as an example, the size of the electrode pad 8 can be reduced to 0.4 mm ^{∗} 0.3 mm, the area of the electrode pad 8 can be reduced by 70%, the corresponding busbar silver paste can be saved by 70%, and the unit consumption of silver paste for the overall cell is reduced by about 14%.

After pre-coating the first solder layer 5 on the electrode pad 8, the weldability is improved, and the defective rate of welding (a relevant defect being rosin joint) can be reduced by about 50% from the current 1.2% (the proportion of rosin joint caused by the fact that the solder layer of the solder strip is not bonded to the electrode pad is about 0.6%, which can be solved by the solution of the present disclosure).

**Table 1**

| The diameter of the solder strip body being 0.3 mm. | Thickness of second solder layer | Size of electrode pad | Proportion of rosin joint |
|---|---|---|---|
| related art | 0.17mm | 0.8 mm ^{∗}0.5 mm | 1.2% |
| The solution of the present disclosure | 0.04mm | 0.4 mm ^{∗}0.3 mm | 0.6% |
| Beneficial Effect | The diameter of the solder strip body remains unchanged, and the solder strip saves about 77.4% of the consumption of the solder layer. | The electrode pad area is reduced by 70%, the corresponding busbar silver paste is saved by 70%, and the unit consumption of silver paste for the overall cell is reduced by about14%. | The proportion of rosin joint caused by the fact that the solder layer of the solder strip is not bonded to the electrode pad is about 0.6%, and the defects caused by rosin joint can be overcome by the solution of the present disclosure. |

In some embodiments provided in the present disclosure, the first solder layer 5 and the second solder layer 7 are made of a same material, and the first solder layer 5 and the second solder layer 7 can be tin-lead alloy solder layers or tin-lead-silver alloy solder layers. These lead-containing solder layers can be, but are not limited to, Sn-Ag, Sn-Pb, Sn-Cu, Sn-Bi, or Sn-Ga-Bi.

In some embodiments provided by the present disclosure, the solder strip body 6 is a copper strip. Copper strips are relatively common in production and their raw materials are easily available. Therefore, it is more convenient to select a copper strip as the solder strip body 6. It is acknowledged by those skilled in the art that, in fact, the solder strip body 6 is not limited to the copper strip, and the copper strip herein is just one solution.

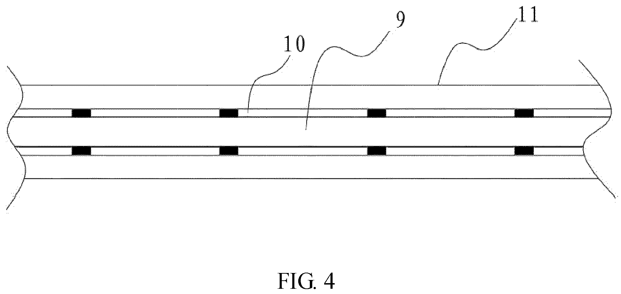

Based on the above embodiments, referring to FIG. 4, the present disclosure further provides a photovoltaic module, and the photovoltaic module includes a cell string 9 formed by connecting multiple cells in sequence, a packaging layer 10 configured to cover a surface of the cell string 9, and a cover 11 configured to cover a surface of the packaging layer 10 away from the cell string 9. Two adjacent cells are connected through the above welding method.

The structures, features and effects of the present disclosure have been described in detail above according to the embodiments shown in the drawings. The above are only some embodiments of the present disclosure, but the scope of the present disclosure is not limited by the drawings. Without departing the spirit covered by the description and drawings, any changes made in accordance with the concept of the present disclosure, or modifications to equivalent embodiments with equivalent changes, shall fall within the scope of the present disclosure.

## Claims

1. A welding method for a photovoltaic cell, wherein a first cell and a second cell are adjacent to each other and are welded to each other by a solder strip;
wherein the welding method for the photovoltaic cell is **characterized by** comprising:
step S1: providing a substrate of each of the first cell and the second cell, and providing a first solder layer at a preset position of the substrate where an electrode pad of the substrate is located; and
step S2: lapping one end of the solder strip on the first solder layer of the first cell, lapping another end of the solder strip on the first solder layer of the second cell, and connecting the first cell and the second cell together by welding.

2. The welding method for the photovoltaic cell according to claim 1, wherein each of the first cell and the second cell comprises an electrode, and the electrode pad is located on the electrode.

3. The welding method for the photovoltaic cell according to claim 1, wherein step S1 comprises:
firstly, infiltrating a coating member with a first solder, drawing the infiltrated coating member the preset position of the substrate, and then heating the coating member in such a manner that the substrate is coated with the first solder to form the first solder layer.

4. The welding method for the photovoltaic cell according to claim 3, wherein the first solder layer has a thickness within a range of 2 µm to 10 µm.

5. The welding method for the photovoltaic cell according to claim 3, wherein the first solder layer is heated at a temperature of 170 °C - 220 °C for less than 10 seconds.

6. The welding method for the photovoltaic cell according to claim 1, wherein a ratio of a width of the first solder layer to a width of the electrode pad is greater than 50%.

7. The welding method for the photovoltaic cell according to claim 1, wherein step S2 comprises:
drawing the solder strip onto the first solder layer, wherein the solder strip comprises a solder strip body and a second solder layer covering the solder strip body; and
lapping the first solder layer with the second solder layer.

8. The welding method for the photovoltaic cell according to claim 7, wherein the second solder layer has a thickness within a range of 1 µm to 13 µm.

9. The welding method for the photovoltaic cell according to claim 7, wherein in a molten state, a ratio of a thickness of the second solder layer to a thickness of the first solder layer is 3:7.

10. The welding method for the photovoltaic cell according to claim 7, wherein in a molten state, the second solder layer has a wetting angle smaller than 90°.

11. The welding method for the photovoltaic cell according to claim 7, wherein the second solder layer is coated on the solder strip body by electroplating or hot dipping.

12. The welding method for the photovoltaic cell according to claim 7, wherein the solder strip body has a diameter of 0.3 mm, and the second solder layer has a thickness of 4 µm.

13. The welding method for the photovoltaic cell according to claim 1, wherein the first solder layer and the second solder layer are tin-lead alloy solder layers or tin-lead-silver alloy solder layers, wherein the tin-lead alloy solder layers and the tin-lead-silver alloy solder layers comprise Sn-Ag, Sn-Pb, Sn-Cu, Sn-Bi, or Sn-Ga-Bi.

14. The welding method for the photovoltaic cell according to claim 1, wherein the electrode pad has a size of 0.8 mm ^{∗} 0.5 mm.

15. A photovoltaic module, comprising:
a cell string formed by connecting a plurality of cells in sequence, two adjacent cells of the plurality of cells being connected to each other through the welding method according to any one of claims 1 to 14;
a packaging layer configured to cover a surface of the cell string; and
a cover configured to cover a surface of the packaging layer away from the cell string.
